# EUROPEAN PATENT APPLICATION

(11) **EP 4 808 297 A2**
(43) Date of publication of application: **16.09.2026**
(21) Application number: 26158958.4
(22) Date of filing: 17.02.2026
(51) Int. Cl.: H05K 7/14

(54) **MODULAR SYSTEM WITH CABLE TERMINAL ISOLATION FOR AN INDUSTRIAL AUTOMATION SYSTEM**

(30) Priority: 25.02.2025 US 202519062544
(71) Applicant: Rockwell Automation Technologies, Inc., Mayfield Heights, OH 44124 (US)
(72) Inventor: Knoll, Karol J., Mayfield Heights, OH, 44124 (US); Styczen, Slawomir, Mayfield Heights, OH, 44124 (US); Najdek, Damian, Mayfield Heights, OH, 44124 (US); Skornicki, Adrian, Mayfield Heights, OH, 44124 (US)
(74) Representative: Grünecker Patent- und Rechtsanwälte PartG mbB

(57) **Abstract**

The present technology relates to a modular industrial automation system that is compliant with 4B separation standards from the International Electrotechnical Commission (IEC) for standard number 61439. In particular, when modular industrial automation systems are implemented, the terminals in the electrical cabling cabinet must be properly electrically isolated to meet requirements. However, due to space limitations, the addition of multiple components horizontally within the system creates horizontal access and isolation issues. Further, due to the space limitations, physically accessing the terminals becomes challenging. As yet another challenge, the cabinet may suffer from overheating issues due to the size of the space and the configuration of the terminals. Finally, to be fully compliant, each terminal within the cabinet must be compliant. Accordingly, the design disclosed allows for avoiding overheating while meeting the requirements and providing accessible terminals.

## Description

### TECHNICAL FIELD

Various embodiments of the present technology relate to industrial automation devices and particularly to cable terminal isolation for terminal access to multiple functional units positioned adjacent to one another in a modular industrial automation system.

### BACKGROUND

Industrial automation environments, such as factories, mills, and the like, employ various industrial automation devices and components such as sensors, actuators, drives, machinery, conveyors, switches, power sources, controllers, processors, and the like to perform industrial processes and automate portions of the industrial process. Some of the industrial automation components may be placed into a modular shelf system beneficial for housing various components in an organized and efficient manner. For example, some switches, drives, controllers, and the like may be suitable for enclosure in a modular shelf system.
A modular system allows for versatility regarding width, height, and depth such that the modular system can be designed to suit its place of installation and ensure that the system can be modified or extended as needed.

The components are arranged within the modular system. The modular system often includes a cable cabinet, which includes terminals for connecting the components to their respective connections in the industrial automation environment. In other words, terminals connected to respective components installed in the modular system allow connections to one or more of the industrial automation devices located outside of the modular system in the industrial automation environment. However, current modular systems suffer from electrical interference between terminals of the components, disorganization, and space constraints within the cable cabinet. Accordingly, improvements are needed to organize and isolate terminal connections of one electrical component from another within the space constrained environment without introducing further overheating issues, which may also plague the space-constrained environment.

### SUMMARY

Systems, devices, and methods are provided herein for isolating terminal connections of distinct industrial automation components that are positioned within a modular system shelf unit. An industrial or commercial environment may include various industrial automation devices (e.g., such as conveyors, robots, motors, belts, and the like) couplable with the electrical components (e.g., controllers, processors, variable speed drives, and other such devices) that control them to perform industrial automation processes. Separating and isolating terminal connections to the electrical components positioned next to each other reduces connection complexity and provides isolation between the terminals of the adjacent components.

In an embodiment of the present technology, a modular enclosure system includes multiple industrial automation component compartments and a cable compartment configured to support a multi-zone terminal box. Each zone of the multi-zone terminal box corresponds with a respective industrial automation component compartment. The multi-zone terminal box may include enclosure walls positioned along boundaries of one or more zones of the multi-zone terminal box such that the enclosure walls include a first side wall, a bottom wall, a top wall assembly, and a front wall assembly. The terminal box also includes an interior wall positioned within the enclosure walls to isolate a first zone from a second zone. There are terminals within each of the first zone and the second zone such that the terminals within the first zone provide access to electrical connections of a first industrial automation component housed within its corresponding industrial automation component compartment; and the terminals within the second zone provide access to electrical connections of a second industrial automation component housed within its corresponding industrial automation component compartment.

Implementations may include one or more of the following features. Optionally, the multi-zone terminal box is compliant with at least one form of the International Electrotechnical Commission (IEC) standard number 61439. Optionally, the cable compartment is configured to support multiple multi-zone terminal boxes each compliant with IEC standard number 61439 such that the modular enclosure system as a whole is compliant with IEC standard number 61439. Optionally, the terminal box and/or the entire modular enclosure system is IEC standard number 61439 form 4B compliant. Optionally, the industrial automation component compartments include a first multi-component shelf configured to support the first industrial automation component and the second industrial automation component. Optionally, the industrial automation components may include a motor controller, a drive, and/or a programmable logic controller. Optionally, the modular enclosure system includes a rail positioned within the enclosure walls of the terminal box that extends within the first and second zones. The modular enclosure system may include a first terminal block positioned on the rail within the first zone that includes the terminals within the first zone and a second terminal block within the second zone that includes the terminals within the second zone. Optionally, the front wall assembly may include a first front wall member having an aperture formed therein to allow cable access to the first terminal block via a first cable extending into the first zone through the aperture. Optionally, the first front wall member is positioned at a 45-degree angle with respect to the top wall assembly. Optionally, the bottom wall has an aperture formed therein to allow cable access to the first terminal block via a first cable extending into the first zone through the aperture. Optionally, the enclosure walls further include a back wall and a second side wall.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

While multiple embodiments are disclosed, still other embodiments of the present technology will become apparent to those skilled in the art from the following detailed description, which shows and describes illustrative embodiments of the invention. As will be realized, the technology is capable of modifications in various aspects, all without departing from the scope of the present invention. Accordingly, the drawings and detailed description are to be regarded as illustrative in nature and not restrictive.

### BRIEF DESCRIPTION OF THE DRAWINGS

Many aspects of the disclosure can be better understood with reference to the following drawings. The components in the drawings are not necessarily drawn to scale. Moreover, in the drawings, like reference numerals designate corresponding parts throughout the several views. While several embodiments are described in connection with these drawings, the disclosure is not limited to the embodiments disclosed herein. On the contrary, the intent is to cover all alternatives, modifications, and equivalents.
FIG. 1 illustrates an example block diagram of an enclosure system for industrial automation in accordance with some embodiments of the present technology.
FIG. 2 illustrates a modular shelving unit for the enclosure system of FIG. 1 in accordance with some embodiments of the present technology.
FIG. 3 illustrates one of the terminal boxes of FIG. 2 in accordance with some embodiments of the present technology.
FIG. 4 illustrates the terminal box of FIG. 3 in accordance with some embodiments of the present technology.
FIG. 5 illustrates another terminal box in accordance with some embodiments of the present technology.
FIG. 6 illustrates a pair of terminal boxes in accordance with some embodiments of the present technology.
FIG. 7 illustrates one of the terminal boxes of FIG. 6 in accordance with some embodiments of the present technology.

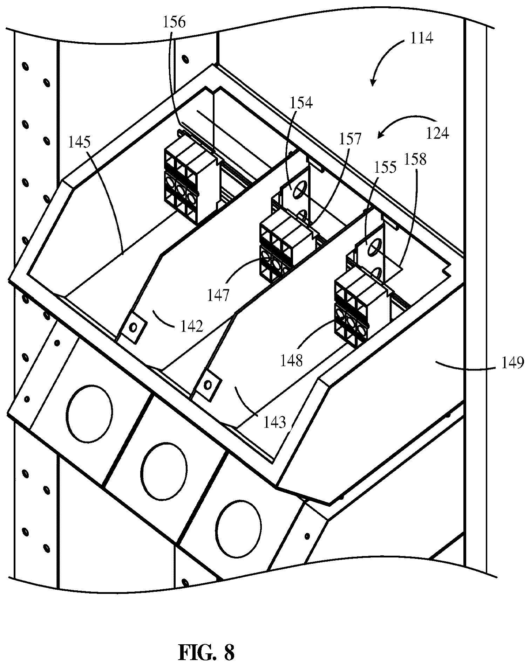

FIG. 8 illustrates one of the terminal boxes of FIG. 6 in accordance with some embodiments of the present technology.

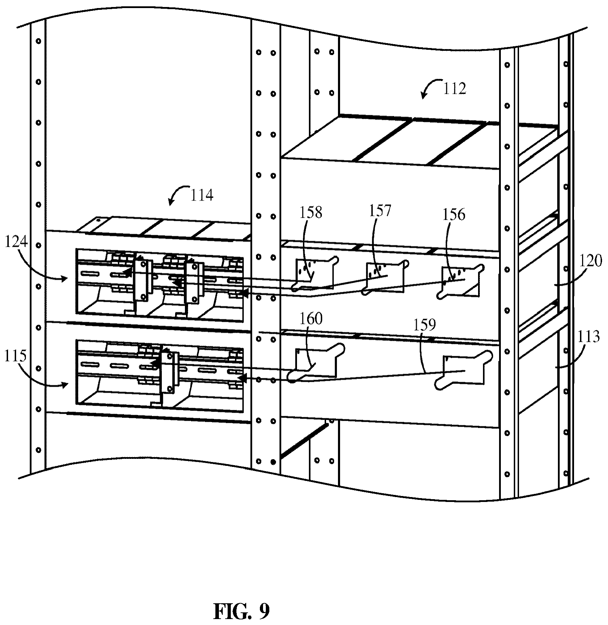

FIG. 9 illustrates a back side of the modular shelving unit of FIG. 2 in accordance with additional embodiments of the present technology.

The drawings have not necessarily been drawn to scale. Similarly, some components or operations may not be separated into different blocks or combined into a single block for the purposes of discussion of some of the embodiments of the present technology. Moreover, while the technology is amendable to various modifications and alternative forms, specific embodiments have been shown by way of example in the drawings and are described in detail below. The intention, however, is not to limit the technology to the particular embodiments described. On the contrary, the technology is intended to cover all modifications, equivalents, and alternatives falling within the scope of the technology as defined by the appended claims.

### DETAILED DESCRIPTION

Various embodiments of the present technology are described herein related to providing terminals for coupling devices of an industrial automation environment with electrical components, and more particularly, to separating and isolating respective terminals of a plurality of electrical components within a terminal enclosure. In industrial and commercial environments, various electronic industrial automation components, such as motor controllers, drives, and programmable logic controllers, and the like are connected with industrial automation devices such as conveyors, motors, pumps, fans, and more, to perform various tasks related to an automation system.

A modular rack or shelving system may be used to provide a layout for a plurality of electrical components conveniently located together and organized according to a defined strategy. Electrical connections to and from the components are typically accessed at the rear of the components located at the back of a shelf of the modular rack on which the electrical component is housed. To provide a connection point for a customer to connect a device to the electrical components, one or more cables extend from the rear of the electrical components and extend into a common area to allow a technician to couple a device to the electrical components without needing to remove the electrical components from the shelving system in order to access the rear of the components. The cables couple a terminal device with a respective electrical component and allow a device to be coupled with the terminal for communications to and from the desired component. One or more terminals can be coupled with a single electrical component and are separated from the terminals of other units via isolation. The various terminal boxes and their embodiments described herein provide separation and isolation of the terminals. By providing such separation and isolation for each terminal connected to an electrical component installed in the shelving unit, the modular system may qualify to be designated according to one or more industry standards. Particularly, the described terminal boxes are IEC standard number 61439 form 4B compliant and also provide physical access to the terminals within the cable cabinet without introducing overheating issues.

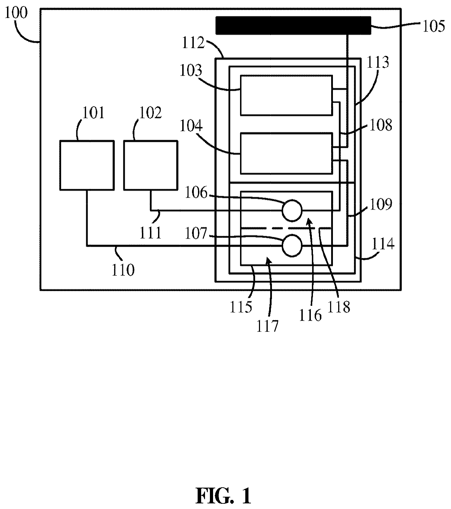

Turning now to the Figures, **FIG. 1** illustrates an example block diagram of an enclosure system for industrial automation in accordance with some embodiments of the present technology. An industrial automation system 100 includes a plurality of industrial automation devices 101, 102 such as motors, belts, conveyors, robots, and the like. These industrial automation devices are not typically self-controlled but are driven by other industrial automation components such as controllers, processors, drives (e.g., variable speed drives), and the like. The industrial automation control components 103, 104 execute instructions and communicate via input/output (I/O) with the industrial automation devices 101, 102 to instruct the industrial automation devices 101, 102 to execute the processes they are designed to perform. Two industrial automation control components 103, 104 are illustrated as controlling components to operate the industrial automation devices 101, 102 according to the desired industrial automation protocol. Power into industrial automation control components 103, 104 is provided by a busbar system 105 with sufficient power to operate industrial automation control components 103, 104 within the industrial automation system 100.

To provide electrical connection between the industrial automation devices 101, 102 and the industrial automation control components 103, 104, terminals 106, 107 are connected via respective cables 108, 109 to the rear or back side of the industrial automation control components 103, 104. By connecting the industrial automation devices 101, 102 to the terminals 106, 107 via terminal cables 110, 111, communications are established between the industrial automation devices 101, 102 and the industrial automation control components 103, 104.

The industrial automation control components 103, 104 and terminals 106, 107 are housed in a modular shelf system 112 that includes a plurality of shelves 113 in one or more columns and one or more rows. Each shelf can house one, two, three, or more industrial automation control components 103, 104 side-by-side, in one example. Further, drawers may be used rather than shelves in some embodiments. As illustrated, shelf 113 houses two industrial automation control components 103 and 104. A cabinet such as cable cabinet or compartment 114 of the modular shelf system 112 provides a space to mount the terminal blocks 106, 107 corresponding with the electrical components 103, 104 on the shelf 113 of the same row. A terminal box 115 includes a plurality of isolation zones 116, 117 into which the terminal blocks 106, 107 are mounted. A removable wall 118 is placed inside the terminal box 115 to create the separate isolation zones 116, 117 as described herein. Terminal box 115 is described in further detail below, but in every embodiment, terminal box 115 may be IEC standard number 61439 compliant, and particularly IEC standard number 61439 form 4B compliant.

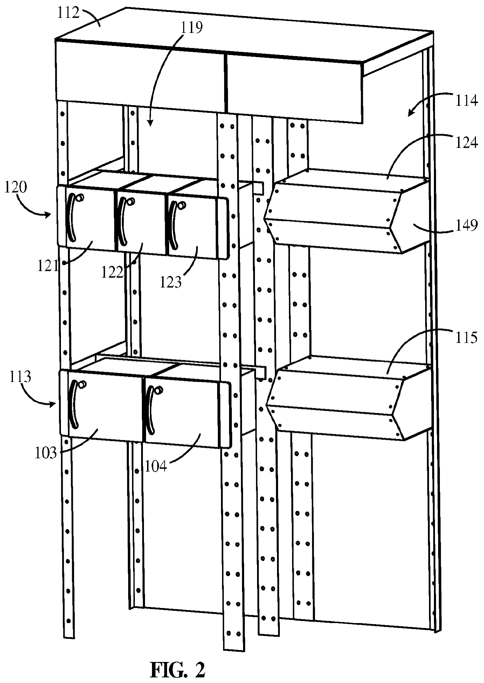

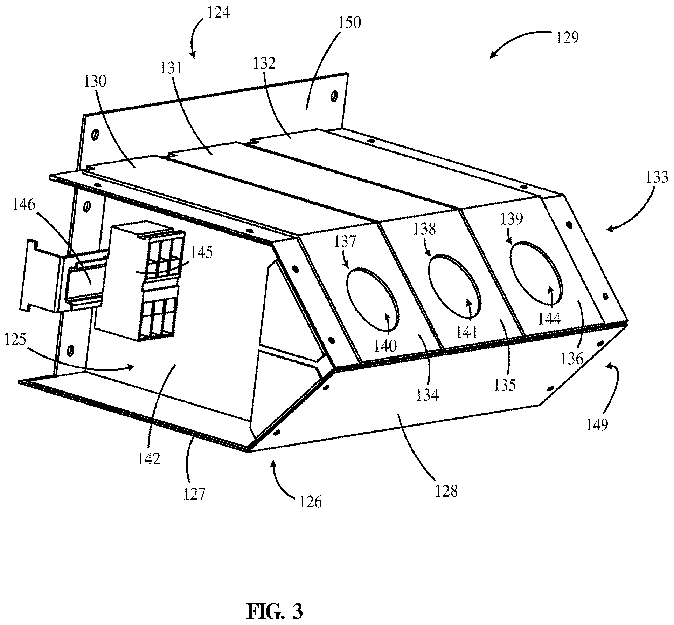

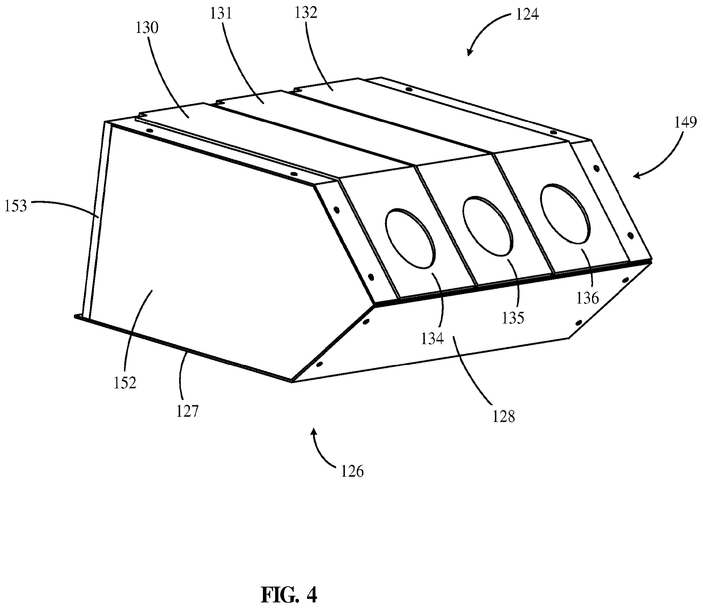

**FIG. 2** illustrates modular shelf system 112 of FIG. 1 in accordance with some embodiments of the present technology. Modular shelf system 112 includes a column of shelves 119 including shelf 113 having two industrial automation control components 103, 104 and another shelf 120 having three industrial automation control components 121, 122, 123. The shelves 113, 120 thus form multi-component shelves. The terminal box 115 is positioned adjacent to the shelf 113 for housing the terminals 106, 107 illustrated in FIG. 1. Another terminal box 124 is positioned adjacent to the shelf 120 for housing terminals (shown in FIGS. 3 and 4 below) therein that allow coupling industrial automation devices to the industrial automation control components 121 - 123. By positioning the terminal boxes 115, 124 adjacent to their respective shelves, cable lengths (e.g., lengths of cables 108, 109) can be shorter, and visual ordering of terminals can be more easily understood by technicians and other personnel.

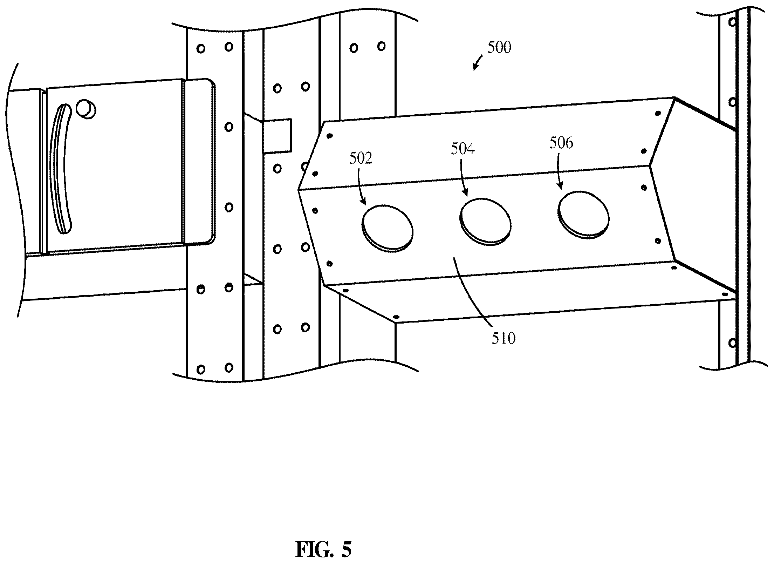

**FIG. 3** illustrates the terminal box 124 of FIG. 2 in accordance with some embodiments of the present technology. The terminal box 124 includes a plurality of enclosure walls that define an interior portion 125 of the terminal box 124. A bottom wall assembly 126 may have a first bottom wall portion 127 and a second bottom wall portion 128. In an embodiment, bottom wall portions 127, 128 may be separately coupled to and removed from the assembly of the terminal box 124. In another embodiment, the bottom wall portions 127, 128 form a single bottom wall that is coupled to and removed from the terminal box 124. As shown, bottom wall portions 127, 128 may be configured such that where bottom wall portion 127 joins bottom wall portion 128, an interior angle is formed such that bottom wall portion 128 angles toward the edge of the front wall assembly 133. A top wall assembly 129 includes a plurality of top wall portions 130, 131, 132. Front wall assembly 133 includes front wall portions 134, 135, 136 that correspond with the top wall portions 130 - 132. Similar to the bottom wall 126, the top and front wall portions 130 - 136 may be separately coupled to and removed from the assembly of the terminal box 124. Alternatively, wall portions 130, 134 may form a first single wall portion, wall portions 131, 135 may form a second single wall portion, and wall portions 132, 136 may form a third single wall portion. As shown, top wall portions 130 - 132 and front wall portions 134 - 136 may be configured such that where top wall portions 130 - 132 join front wall portions 134 - 136, an interior angle is formed such that front wall portions 134 - 136 angle toward the edge of bottom wall portion 128. A cable aperture 137, 138, 139 is formed in each of the front wall portions 134, 135, 136. In another embodiment, the first and second bottom wall portions 127, 128 may be formed of individual wall portions similar to the top and front wall assemblies 129, 133. In other embodiments, apertures 127 - 139 are formed in bottom wall portion 128, which is depicted in FIG. 5. Note that front wall portions 134 - 136 may be independently flipped open such that physical access to terminals (e.g., terminal block 145) is easily accessible.

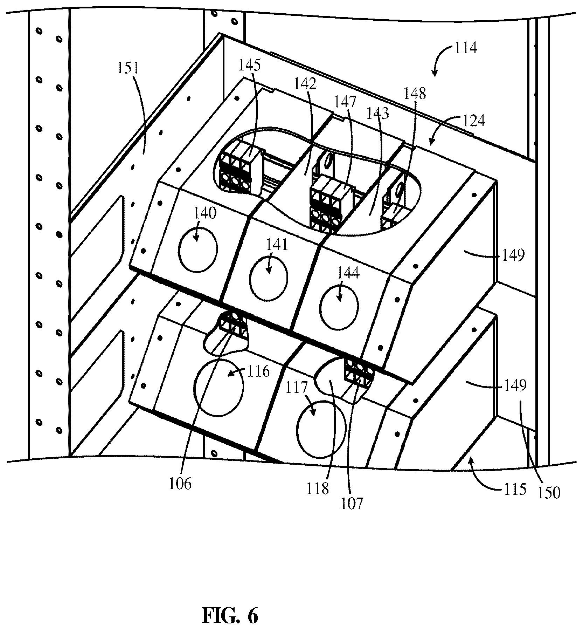

The terminal box 124 is illustrated as a multi-zone terminal box having three isolation zones. A first isolation zone 140 partially bounded by the wall portions 130, 134 is separated from a second isolation zone 141 partially bounded by the wall portions 131, 135 by a first interior wall 142 (e.g., a dividing plate). A second interior wall 143 (e.g., a second dividing plate; see FIG. 6) separates the second isolation zone 141 from a third isolation zone 144 partially bounded by the wall portions 132, 136.

A terminal block 145, installed on a rail 146 (e.g., a DIN rail), is positioned within the first isolation zone 140 and is couplable with an electrical component (e.g., industrial automation control component 103 of FIG. 1) and with a device (e.g., industrial automation device 102 of FIG. 1).The rail 146 extends throughout the first, second, and third isolation zones 140, 141, 144 and is orthogonal to the first and second interior walls 142, 143. In one embodiment, the terminal block 145 couples with the electrical component in a rear side of the terminal block 145 and couples with the device in a front side of the terminal block 145. The front side, which faces the cable aperture 137 of the front wall portion 134, allows a cable (e.g., terminal cable 111 of FIG. 1) coupled with the device to be connected with the terminal block 145 while the terminal box 124 is installed within the cable cabinet 114. The cable apertures 137, 138, 139, while allowing cables to pass therethrough, provide isolation from the isolation zones 140, 141, 143 from the environment of the cable compartment 114 external to the isolation zones. In one example, the front wall portion 134 by itself (or together with the corresponding first top wall portion 130 in one embodiment) may be removed from the terminal box 124 or opened independently from any of the other front wall portions (e.g., front wall portions 135, 136), and the terminal cable 111 may be inserted through the cable aperture 137 of the front wall portion 134. The angled access through front wall portions 134 - 136 allow for access even when multiple terminal boxes 124 are stacked closely above and below (e.g., vertically) within cable cabinet 114. Cable ends of the terminal cable 111 may then be connected with the terminal block 145, and the front wall portion 134 (and the first top wall portion 130 if also removed) may then be attached to the terminal box 124 so that the terminal cable 111 extends from the device external to the cable cabinet 114 and through the cable aperture 137 and into the terminal block 145 within the first isolation zone 140. In some embodiments, the front wall portion 134 may remain attached to the terminal box 124 or to the first top wall portion 130 via a hinge (not shown) to be rotated away from the first isolation zone 140 to allow a technician or other personnel to access the first isolation zone 140 as needed. Each of the other zones within the terminal box 124 (e.g., the second and third isolation zones 141, 144) may be accessed as described above with respect to the first isolation zone 140. That is, the front wall portion 135 may be removed to allow cable ends of a terminal cable to be connected with a terminal block 147 (FIG. 6) positioned on the rail 146 within the second isolation zone 141, and the front wall portion 136 may be removed to allow cable ends of a terminal cable to be connected with a terminal block 148 (FIG. 6) positioned on the rail 146 within the third isolation zone 144.

A first side wall 149 (also illustrated in FIG. 2) of the terminal box 124 separates the third isolation zone 144 from an interior volume of the cable cabinet 114. In the embodiment shown in FIG. 3, the terminal box 124 is couplable with a rear wall 150 and a side wall 151 (FIG. 6) of the cable cabinet 114 provide supports for mounting the terminal boxes 115, 124. In this manner, a plurality of enclosure walls formed by one or more of the top wall assembly 129, bottom wall 126, first side wall 149 are positioned along boundaries of the multiple zones 140, 141, 144 of the interior portion 125 of the terminal box 124. In the embodiment illustrated in FIG. 3, the rear and side walls 150, 151 also form boundaries of the zones 140, 141, 144.

In another embodiment illustrated in **FIG. 4****,** a second side wall 152 and a rear box wall 153 are attached to the terminal box 124 to provide additional boundaries for the multiple zones 140, 141, 144 and may replace the rear and side walls 150, 151 as boundaries.

The front wall portions 134-136 are positioned at an angle with respect to the first top wall portions 130-132. In this manner, cables from the devices in the industrial automation system external to the cable cabinet 114 that are inserted through the cable apertures 137-139 to be connected with the terminal blocks 145, 147, 148 may have a more gradual bend than a bend formable in a front wall portion positioned at a 90-degree angle with respect to the first top wall portions 130-132. Other angles are contemplated to provide alternative cable bending strategies for the modular shelf system as well as for easier physical access within the various isolation zones. Additionally, rubber grommets may be disposed about apertures 137 - 139 to ensure cables are not damaged by the edges of the apertures 137 - 139. These grommets may be used to meet other standards including IEC standard number 60529 IP2XB. Other apertures discussed through which cables may extend within and throughout the isolation zones may also be protected with grommets.

**FIG. 5** illustrates another example of a terminal box 500 which may be similar to terminal box 124. One difference depicted is that apertures 502, 504, 506 may be formed in the second bottom wall portion 510. Apertures 502, 504, 506 may be substantially the same as apertures 137, 138, 139 of the previous FIGS. Further, second bottom wall portion 510 may be substantially the same as second bottom wall portion 128 of the previous FIGS. In addition, cable apertures may be formed in both the second top and bottom wall portions to allow for configurability options within the industrial automation environment.

**FIG. 6** illustrates the terminal boxes 115, 124 in accordance with some embodiments of the present technology. The terminal boxes 115, 124 are shown installed in the cable cabinet 114 and correspond with terminal box embodiments illustrated, for example, in FIG. 3, which use the rear wall 150 and the side wall 151 of the cable cabinet 114 to provide boundaries for the internal zones within the terminal boxes 115, 124. As stated above, other embodiments for the terminal boxes 115, 124 may include respective second side walls 152 and rear box walls 153, even if installed against the rear and side walls 150, 151 of the cable cabinet 114 as illustrated in FIG. 6. While the terminal box 124 includes the two interior walls 142, 143 for separation of the three isolation zones 140, 141, 144, the terminal box 115 only includes the single interior wall 118 for separating the two isolation zones 116, 117.

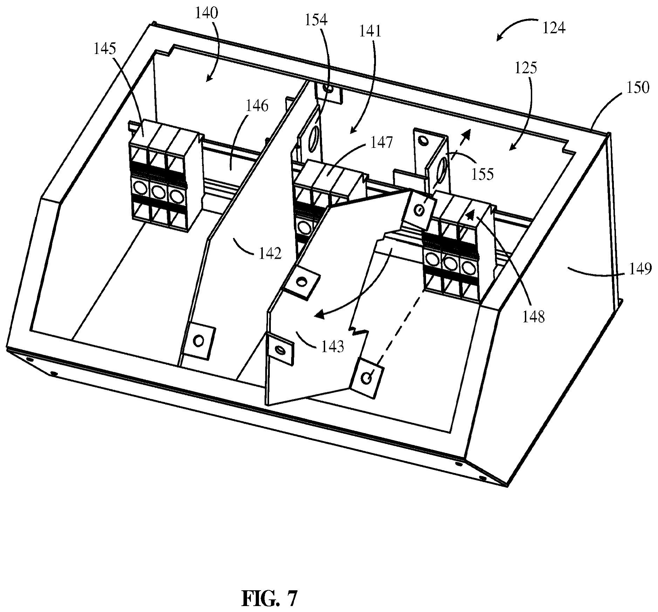

**FIG. 7** illustrates the interior portion 125 of the terminal box 124 in accordance with some embodiments of the present technology. The first interior wall 142 is shown installed within the interior portion 125 and separating the first isolation zone 140 from the second isolation zone 141. The second interior wall 143, when installed within the interior portion 125 separates the second isolation zone 141 from the third isolation zone 144. However, as illustrated, the second interior wall 143 is removable from the terminal box 124. Accordingly, the second and third isolation zones 141, 144 combine together to form a larger isolation zone. While not shown as being removed, the first interior wall 142 is also removable from the terminal box 124 in some embodiments. If the first interior wall 142 is removed, the first isolation zone 140 combines with the second isolation zone 141 or the larger zone formed by the removal of the third isolation zone 144 to form another, larger isolation zone. While two interior walls 142, 143 (i.e., dividing plates) are depicted in FIG. 7, any number of interior walls may be included to further subdivide the terminal box 124 to accommodate any size modular system. In embodiments in which the dividing plates (e.g., first interior wall 142 and/or second interior wall 143) are removeable, they may be moveable to modify the size of any of the interior isolation zones by moving them independently left or right, by adding more dividing plates, or by removing some or all of the dividing plates. Further, they may be moveable and able to be added or removed without disassembly of the terminal box 124. For example, the front portion of the terminal box 124 that may be opened via a hinge (e.g., front wall portions 134, 135, 136) may be opened and the dividing plates may be added, removed, or moved left or right, as needed, without disassembling the terminal box 124. The dividing plates may be clipped into place with a clipping mechanism or other, disconnectable fastening assembly.

Cable guides 154, 155 or cable guiding panels are aligned with respective interior walls 142, 143 are attached to the rail 146 and/or the rear wall 150 of the cable cabinet 114 and independently remain within the interior portion 125 of the terminal box 124 with removal of either or both of the interior walls 142, 143. Removal of the second interior wall 143 only maintains separation and isolation of the terminal block 145 from the terminal blocks 147, 148; however, the terminal block 147 would no longer be able to be labeled as isolated from the terminal block 148 if connected to different electrical components (e.g., electrical components 103, 104). However, if terminal blocks 147, 148 are connected to the same electrical component, isolation may still be maintained. While not illustrated, grommets may be installed in the apertures of the cable guides 154, 155 to provide protection to the wire coatings and jackets extending through the guides from wear and tear via the cable apertures.

Referring to **FIGS**. **8** and **9****,** cable routes 156 - 160 are illustrated extending from shelves 113, 120 into respective isolation zones of the terminal boxes 115, 124. Routing cables along routes 156 - 160 to connect electrical components on the shelving side of the modular shelf system 112 with the corresponding terminals (e.g., terminal blocks) in the terminal boxes 115, 124 as shown organizes the electrical components and the terminal blocks according to their installed positions. For example, connecting a cable from the industrial automation control component 121 (in the left-most position on the shelf 120) with the terminal block 145 (in the left-most first isolation zone 140 of the terminal box 124) associates the left industrial automation control component with the left terminal block. Similar associations are generated by connecting middle- and right-most industrial automation control components to middle- and right-most terminal blocks. The apertures formed in the cable guides 154, 155 allow passage of cables along the multi-zone cable routes 157, 158, 160, for example, to extend between adjacent isolation zones 116, 117 and 140, 141, 144. In this manner, a technician accessing a target terminal block may know that the target terminal block is connected to the electrical component installed in the same position (e.g., left, right, middle) of the shelf at the same vertical level. Accordingly, industrial automation system installation, setup, and maintenance can be simplified based on electrical component/terminal block positioning.

By using embodiments and aspects of this disclosure, modular industrial automation systems can be fully compliant with IEC standard number 61439 form 4B separation requirements. The particular configurations shown are not limiting, and configurations may be used in modular systems using 1 x 1, 1.5 x 1, and any other suitable sized multi-drawer units. Utilizing small spaces inside a wireway compartment is beneficial. Combining large amperage terminal boxes with dividing plates, grommets, and DIN rails as described herein provide valuable solutions against internal arc propagation and allows for designating the modular shelf system as being 4B separation compliant.

As will be appreciated by one skilled in the art, aspects of the present invention may be embodied as a system, method, computer program product, and other configurable systems. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer readable program code embodied thereon.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number, respectively. The word "or," in reference to a list of two or more items, covers all of the following interpretations of the word: any of the items in the list, all of the items in the list, and any combination of the items in the list.

While specific examples for the technology are described above for illustrative purposes, various equivalent modifications are possible within the scope of the technology, as those skilled in the relevant art will recognize. For example, while processes or blocks are presented in a given order, alternative implementations may perform routines having steps, or employ systems having blocks, in a different order, and some processes or blocks may be deleted, moved, added, subdivided, combined, and/or modified to provide alternative or subcombinations. Each of these processes or blocks may be implemented in a variety of different ways. Also, while processes or blocks are at times shown as being performed in series, these processes or blocks may instead be performed or implemented in parallel or may be performed at different times. Further any specific numbers noted herein are only examples: alternative implementations may employ differing values or ranges.

These and other changes can be made to the technology in light of the above Detailed Description. While the above description describes certain examples of the technology, and describes the best mode contemplated, no matter how detailed the above appears in text, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the above Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms. For example, while only one aspect of the technology is recited as a computer-readable medium claim, other aspects may likewise be embodied as a computer-readable medium claim, or in other forms, such as being embodied in a means-plus-function claim. Any claims intended to be treated under 35 U.S.C. § 112(f) will begin with the words "means for" but use of the term "for" in any other context is not intended to invoke treatment under 35 U.S.C. § 112(f). Accordingly, the applicant reserves the right to pursue additional claims after filing this application to pursue such additional claim forms, in either this application or in a continuing application.

## Claims

1. A modular enclosure system, comprising:
a plurality of industrial automation component compartments;
a cable compartment configured to support a multi-zone terminal box, wherein each zone of the multi-zone terminal box corresponds with a respective industrial automation component compartment;
the multi-zone terminal box comprising:
a plurality of enclosure walls positioned along boundaries of one or more zones of the multi-zone terminal box, wherein the plurality of enclosure walls comprises:
a first side wall;
a bottom wall;
a top wall assembly; and
a front wall assembly,
an interior wall positioned within the plurality of enclosure walls to isolate a first zone within the plurality of enclosure walls from a second zone within the plurality of enclosure walls, and
terminals within each of the first zone and the second zone, wherein:
the terminals within the first zone provide access to electrical connections of a first industrial automation component housed within its corresponding industrial automation component compartment; and
the terminals within the second zone provide access to electrical connections of a second industrial automation component housed within its corresponding industrial automation component compartment.

2. The modular enclosure system of claim 1, wherein the multi-zone terminal box is compliant with at least one form of the International Electrotechnical Commission (IEC) standard number 61439.

3. The modular enclosure system of claim 2, wherein the cable compartment is configured to support a plurality of multi-zone terminal boxes each compliant with the at least one form of the IEC standard number 61439 such that the modular enclosure system is compliant with the at least one form of the IEC standard number 61439.

4. The modular enclosure system of claim 2 or 3, wherein the at least one form is form 4B.

5. The modular enclosure system of one of claims 1 to 4, wherein:
the plurality of industrial automation component compartments comprises a first multi-component shelf configured to support the first industrial automation component and the second industrial automation component; and
wherein at least one of the first industrial automation component and the second industrial automation component comprises one of a motor controller, a drive, and a programmable logic controller.

6. The modular enclosure system of one of claims 1 to 5, further comprising:
a rail positioned within the plurality of enclosure walls and extending within the first and second zones.

7. The modular enclosure system of claim 6, further comprising:
a first terminal block positioned on the rail within the first zone and comprising the terminals within the first zone; and
a second terminal block within the second zone and comprising the terminals within the second zone.

8. The modular enclosure system of claim 7, at least one of:
wherein the front wall assembly comprises a first front wall member having an aperture formed therein to allow cable access to the first terminal block via a first cable extending into the first zone through the aperture, wherein preferably the first front wall member is positioned at a 45-degree angle with respect to the top wall assembly; and
wherein the bottom wall has an aperture formed therein to allow cable access to the first terminal block via a first cable extending into the first zone through the aperture.

9. The modular enclosure system of one of claims 1 to 8, at least one of:
wherein the plurality of enclosure walls further comprises:
a back wall; and
a second side wall;
wherein the cable compartment comprises:
a compartment back wall; and
a compartment side wall, wherein:
the multi-zone terminal box is fastened to the compartment back wall and to the compartment side wall; and
the compartment back wall and the compartment side wall form boundaries of the one or more zones of the multi-zone terminal box;
further comprising a second interior wall positioned within the plurality of enclosure walls to isolate a third zone from the first zone and the second zone within the plurality of enclosure walls; and
wherein the interior wall is removable.

10. An industrial automation assembly, comprising:
a shelving unit for a plurality of industrial automation devices;
an isolation cabinet configured to isolate one or more groups of electrical terminals; and
a terminal box positioned within the isolation cabinet and comprising:
a first side wall,
a bottom wall,
a top wall assembly,
a front wall assembly, and
an interior wall, wherein:
the first side wall, the bottom wall, the top wall assembly, and the front wall assembly define boundaries of an interior volume of the terminal box; and
the interior wall extends through a portion of the interior volume and is configured to separate multiple isolation areas within the interior volume.

11. The industrial automation assembly of claim 10, further comprising:
a back wall; and
a second side wall, wherein the back wall and the second side wall further define boundaries of the interior volume.

12. The industrial automation assembly of claim 11, further comprising:
a first cable guiding panel aligned with the first interior wall, the first cable guiding panel comprising an aperture formed therethrough and configured to allow passage of one or more cables from a first isolation area of the multiple isolation areas to a second isolation area of the multiple isolation areas.

13. The industrial automation assembly of one of claims 10 to 12, further comprising:
a rail extending through a second portion of the interior volume; and
a second interior wall extending through a third portion of the interior volume orthogonally to the rail, wherein:
the interior wall is configured to separate a first isolation area of the multiple isolation areas from a second isolation area of the multiple isolation areas, and
the second interior wall is configured to separate the first isolation area and the second isolation area from a third isolation area of the multiple isolation areas.

14. The industrial automation assembly of claim 13, wherein:
the first interior wall is removable from the interior volume independently of the second interior wall; and
in response to removal of the first interior wall, the first isolation area and the second isolation area form a combined isolation area.

15. The industrial automation assembly of one of claims 10 to 14, wherein:
the top wall assembly comprises a plurality of top wall members;
the front wall assembly comprises a plurality of front wall members;
a first top wall member of the plurality of top wall members and a first front wall member of the plurality of front wall members define boundaries of a first isolation area of the multiple isolation areas;
a second top wall member of the plurality of top wall members and a second front wall member of the plurality of front wall members define boundaries of a second isolation area of the multiple isolation areas;
a first aperture formed in the first front wall member provides cable access to the first isolation area from an environment external to the terminal box; and
a second aperture formed in the second front wall member provides cable access to the second isolation area from the environment external to the terminal box.
